# EUROPEAN PATENT APPLICATION

(11) **EP 1 276 188 A2**
(43) Date of publication of application: **15.01.2003**
(21) Application number: 01108647.7
(22) Date of filing: 05.04.2001
(51) Int. Cl.: H01S 5/183

(54) **A vertical-cavity surface-emitting laser with enhanced transverse mode stability and polarization stable single mode output**

(71) Applicant: Avalon Photonics AG, 8048 Zürich (CH)
(72) Inventor: Monti di Sopra, Fabrice, 8049 Zürich (CH); Moser, Michael, Dr., 5400 Baden (CH)
(74) Representative: Grünecker, Kinkeldey, Stockmair & Schwanhäusser Anwaltssozietät

(57) **Abstract**

A vertical-surface-emitting laser comprises: a first reflector means and a second reflector means arranged to define a laser resonator extending along a longitudinal direction and along transverse directions, a laser active region located between the first and second reflector means, a metal layer at the first or second reflector means and patterned to form a radiation emission window, and a phase matching layer arranged within the resonator and having an optical thickness adapted to transversely pattern a reflectivity of the first and/or second reflector means. The VCSEL device may further comprise an aperture formed between the first and second reflector means. The mode selectivity of the VCSEL is substantially determined by a reflectivity difference defined by the transverse dimensions of the radiation emission window. Moreover, one linear polarization state is stabilized by breaking the cylindrical symmetry of the VCSEL.

## Description

The present invention relates to a vertical-cavity surface-emitting laser (VCSEL) comprising a first reflector means and a second reflector means arranged to define a laser resonator extending along a longitudinal direction and along transverse directions, a laser active region located between the first and second reflector means, a phase matching layer arranged within the laser resonator, and a metal layer at the first and second reflector means and patterned to form a radiation emission window, wherein an optical thickness of the phase matching layer is adapted to transversely pattern a reflectivity of the first and/or reflector means. Moreover, the present invention relates to a VCSEL having the above-identified features, wherein one of two linear polarization directions is stabilized.

Semiconductor laser devices are steadily gaining in importance in a plurality of industrial applications. In particular, in the fields of gas spectroscopy, sensing, coupling of laser light into optical fibers, pumping applications and in communication systems requiring a high transmission rate, semiconductor laser devices with high spectral purity, i.e. with single mode radiation in the longitudinal as well as the transverse directions are highly desirable. Due to the short resonant cavity (vertical cavity), typically in the range of one lambda of the emitted wavelength, VCSEL devices generate a radiation in the fundamental longitudinal radiation mode. The transverse extension of the cavity of a VCSEL, in general, is considerably larger than the longitudinal extension of the cavity, and hence a plurality of transverse modes may appear in the emitted laser beam. The wavelength of the transverse radiation modes may differ from the wavelength of the fundamental transverse radiation mode (in the following, referred to as "fundamental mode") by tenths of gigahertz (GHz). In applications requiring a high spectral purity, i.e. in applications where the wavelength of the emitted laser light has to be stable and should be emitted in a single transverse radiation mode with a mode suppression of typically 10-30 decibels, so-called single mode devices are employed. Such devices are advantageously used in sensing applications, spectroscopy and pumping due to the spectral purity and are also advantageous in data communication systems due to the lower noise level, better fiber coupling efficiency and decreased dispersion. Hence, great effort has been made to provide single mode VCSEL devices.

For example, in *IEEE Photonics Technology Letters,* Vol. 9, No. 10, October 1997, pages 1304-1306, a VCSEL is disclosed comprising one or more oxide layers formed by selective oxidation in a Bragg mirror. This oxide layer serves as a current aperture as well as an optical aperture restricting the optical cavity in the transverse directions. By means of this oxidation layer, the lowest order radiation mode may be selected. For incorporating the oxide layer into the Bragg mirror, however, an additional manufacturing process step is required, resulting in increased cost and lower production yield. Moreover, due to the limited lifetime of laser devices having selectively oxidized layers, such laser devices are merely used in the fields of research and development, rather than for industrial applications.

In *Applied Physical Letters,* Vol. 72, No. 26, June 1998, pages 345-347, a VCSEL device is disclosed having a surface that is treated by means of etching processes to generate to fine structure on top of the surface. This additional structure increases the optical losses of the radiation having transverse radiation modes of higher order, thereby providing selectivity and preferred amplification of the lowest order mode. As in the above case, these devices require an additional process step in manufacturing the device and this additional step of generating said etched structure demands high accuracy and control in both the transverse position and the depth of the structure.

In *IEEE Photonics Technology Letters,* Vol. 6, No. 3, February 1994, pages 323-325, a VCSEL is described comprising a loss-guided or "anti-guided" structure exhibiting in the area of the distributed Bragg reflector (DBR) side of the mesa structure a higher reflective index than in the DBR area below the mesa. Thereby, increased optical losses of the higher order radiation modes are achieved. The manufacturing of the anti-guided structure, however, requires a second apitaxial growth step resulting in a considerably increased production time and higher costs of such laser devices.

In many current VCSEL devices, improvements of the performance is obtained by providing electrical and optical confinement. Thus, corresponding apertures are provided in the VCSEL devices, i.e. a material layer comprising an aperture, wherein the material surrounding the aperture exhibits a higher electrical resistance and a higher optical absorption than the aperture to improve the electro-optical characteristics of the device. Selective oxidation, proton implantation, or a combination of both are employed to form a corresponding aperture to enhance output power as well as to attain lower threshold currents, an increased efficiency and a higher spectral purity. A major drawback of this arrangement, however, resides in the fact that a single mode operation of the VCSEL device requires the aperture to be relatively small, typically in the range of 1-5 micrometers, resulting in an considerably increased current density in the aperture which, in turn, significantly reduces device life-time and reliability.

A further significant disadvantage of single mode VCSEL devices is the undetermined polarization state of the fundamental mode. The fundamental mode of a VCSEL formed on a [100] substrate has substantially two orthogonally polarized components that are spectrally separated by some gigahertz. Due to quantum mechanical fluctuations, an abrupt change of the polarization direction, a so-called polarization flip, is often observed in single mode devices, in particular when the device is operated within a large injection current range. These polarization flips inhibit accurate measurements or data transmission with low bit error rates.

Thus, it is an object of the present invention to provide a VCSEL device having high device reliability and a long and improved durability. A further object of the present invention is to provide a VCSEL device capable of emitting in the fundamental radiation mode, wherein polarization flips are significantly reduced.

According to a first aspect of the present invention, a VCSEL is provided, comprising a first reflector means and a second reflector means arranged to define a laser resonator extending along a longitudinal direction and along transverse directions, a laser active region located between first and second reflector means, a metal layer at the first or second reflector means and patterned to form a radiation emission window, a phase matching layer arranged in the resonator and having an optical thickness adapted to generate a reflectivity difference of the first and/or second reflector means at a resonator region corresponding to the radiation emission window and the residual resonator region, and an aperture formed between the first and second reflector means, wherein a mode selectivity of the VCSEL is substantially determined by reflectivity difference created by the phase matching layer.

In accordance with the first aspect of the present invention, the optical thickness of the phase matching layer is adjusted to create a significant reflectivity difference between the region covered by the radiation emission window and the residual resonator regions. Preferably, the reflectivity of the residual resonator regions is significantly reduced to favor emission of the fundamental mode having its intensity maximum at a region corresponding to the radiation emission window. Consequently, the selection of the fundamental mode is primarily determined by the lateral extension of the radiation emission window rather than by the aperture as in prior art devices. Accordingly, the size of the aperture may exceed the size of the radiation emission window and may be optimized to provide a minimum required degree of current confinement while at the same time maintaining the current density within a range that does not degrade the reliability of the device. For a VCSEL device having cylindrical symmetry, i.e., having a substantially cylindrical laser resonator, a diameter of the radiation emission window may be made to about 1 - 7 µm to select the fundamental radiation mode, whereas the diameter of the aperture is selected to approximately 2 - 10 µm. Thus, the current density is reduced by a factor of about 2 compared to a prior art device requiring an aperture of 5 µm in diameter to select the fundamental mode.

According to a further aspect of the present invention, a VCSEL comprises a first reflector means and a second reflector means arranged to define a laser resonator extending along a longitudinal direction and along transverse directions represented by a first transverse direction and a second transverse direction, a laser active region located between the first and second reflector means, a metal layer provided at the first or second reflector means and patterned to form a radiation emission window having a first lateral extension along the first transverse direction and a second lateral extension along the second transverse direction, a phase matching layer arranged in the laser resonator and having an optical thickness adapted to reduce the reflectivity of the first and/or second reflector means at an area not covered by the radiation emission window to select the fundamental transverse radiation mode. The VCSEL is characterized in that the first lateral extension is different from the second lateral extension to cause a direction-dependent loss of the transverse radiation mode.

As previously explained, VCSEL devices emit linearly polarized light with a weak elliptical component. The direction of the polarization depends on any anisotropies prevailing in the VCSEL device. In a VCSEL device having a cylindrical symmetry with respect to the longitudinal axis, i.e. a VCSEL device having a substantially cylindrical resonator geometry, the anisotropy caused by the crystal directions determines the possible polarization directions. Most of the VCSEL devices are grown on a [100] substrate, which leads to a linear polarization along the [011] or [01-1] crystal direction. Upon varying operation conditions, in particular a variation of the drive current, a spontaneous polarization flip between these two linear polarization directions can frequently be observed. In optical systems employing polarization sensitive components, however the polarization direction of the VCSEL has to be oriented in a predefined direction and has to be stable over a wide range of drive currents. Since the two polarization components of the fundamental mode are spectrally separated by typically 1-20 GHz, the difference in wavelength between the two polarization states is well above the required accuracy for applications such as sensing, pumping, spectroscopy and the like. Moreover, in data communication, a polarization flip introduces additional noise and thus increases the bit error rate. Measurements have shown that the relative-intensity noise can increase by several orders of magnitude in the presence of a polarization flip. Moreover, in wavelength division multiplex (WDM) applications with spectrally closely-spaced channels, a polarization flip might lead to an incorrect signal transmission.

Due to the different extension of the radiation emission window along the first and second transverse directions, the reflectivity difference created by the phase matching layer is also patterned in accordance with the shape of the radiation emission window. As a consequence, an additional anisotropy is introduced and selectively breaks the cylindrical symmetry within the device. Thus, the radiation losses within the resonator are different for the first and second transverse directions and will therefore favor one of the two polarization directions. Preferably, the first and second directions are selected to substantially coincide with the two possible linear polarization directions.

According to another aspect of the present invention, a VCSEL device comprises a first reflector means and a second reflector means arranged to define a laser resonator extending along a longitudinal direction and along transverse directions represented by a first transverse direction and a second transverse direction, a laser active region located between the first and second reflector means, a metal layer provided at the first or second reflector means and patterned to form a radiation emission window, a phase matching layer arranged in the laser resonator and having an optical thickness adapted to reduce the reflectivity of the first and/or second reflector means at an area not covered by the radiation emission window to select the fundamental transverse radiation mode, and an aperture formed between the first and second reflector means, wherein a center of the aperture and a center of the radiation emission window are located on different longitudinal axes.

According to this aspect, the centers of the aperture and the radiation emission window are offset to each other. The finally established intensity distribution of the fundamental radiation mode is substantially determined by the superposition of the individual intensity distributions effected by the aperture and the reflectivity difference, respectively. Consequently, the resulting asymmetric distribution favors the occurrence of a single polarization state, in particular when the offset between the aperture and the radiation emission window is oriented along one of the two linear polarization directions.

According to still another aspect of the present invention, a VCSEL comprises a first reflector means and a second reflector means arranged to define a laser resonator extending along a longitudinal direction and along transverse directions represented by a first transverse direction and a second transverse direction, a laser active region located between the first and second reflector means, a metal layer at the first or second reflector means, patterned to form a radiation emission window, and a phase matching layer arranged in the laser resonator and having an optical thickness adapted to reduce the reflectivity of the first/and or second reflector means at an area not covered by the radiation emission window to select the fundamental transverse radiation mode. The VCSEL further comprises a fine grid within the radiation emission window, the fine grid having a first periodicity along the first transverse direction and/or a second periodicity along the second transverse direction, wherein the first periodicity is different from the second periodicity.

The fine grid provided within the radiation emission window allows to define a "fine" structure within the radiation emission window and thus the radiation field within the resonator experiences a "disturbance" defined by the first and/or second periodicities of the fine grid. Since the first and second periodicities are different from each other, the disturbance and thus the finally established distribution of the radiation field is asymmetric with respect to the first and second transverse directions. This asymmetry will finally lead to a stable polarization and will therefore significantly reduce polarization flips in the emitted laser beam.

Further advantages, objects as well as further embodiments are defined in the dependent claims.

In the following, the present invention will be explained in more detail with reference to the drawings, in which:
Figure 1 is a schematic cross-sectional view of an illustrative embodiment according to the present invention;
Figure 2 is a graph depicting the reflectivities of a Bragg reflector covered with a phase matching layer alone (solid line) and additionally with a metal layer (broken line), with respect to the thickness of the phase matching layer;
Figure 3 is a graph depicting the difference of the reflectivities of a Bragg reflector covered with the phase matching layer and with or without the metal layer with respect to the number of pairs of Bragg layers;
Figure 4 is graph showing the reflectivity of a Bragg reflector with respect to the number of pairs of layers having a high index of refraction and a low index of reflection in an alternating fashion;
Figures 5a-5c show schematic top views of various embodiments for achieving an asymmetric distribution of the radiation field within the resonator of the VCSEL;
Figure 5d is a graph for explaining the principal of obtaining an asymmetric field distribution; and
Figure 6 is a schematic top view depicting an illustrative embodiment having an additional fine structure in the radiation emission window that is effected by a fine grid.

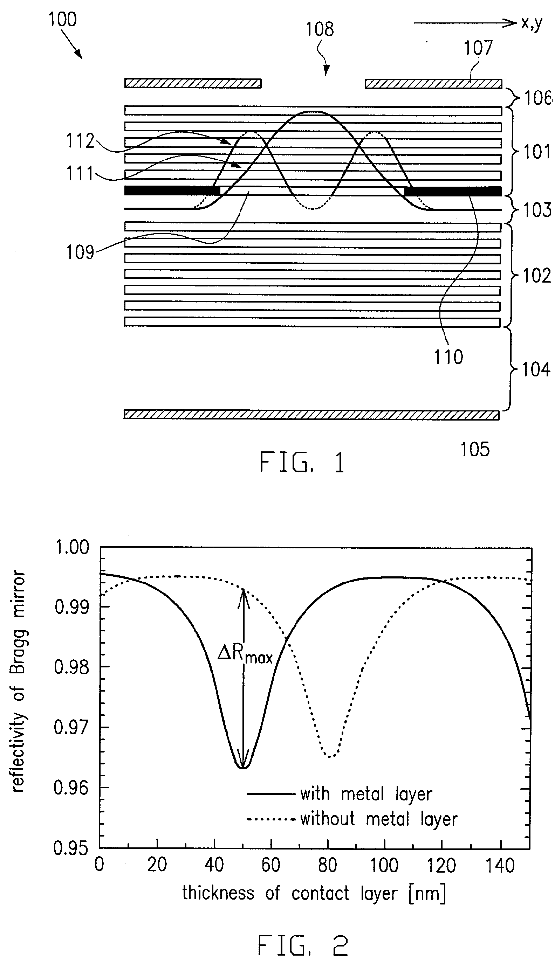

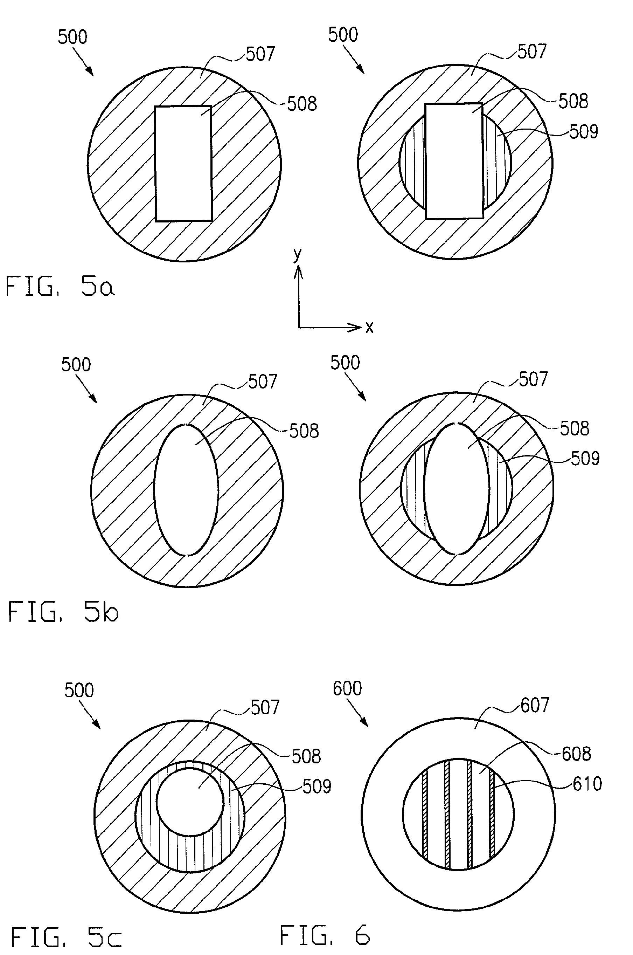

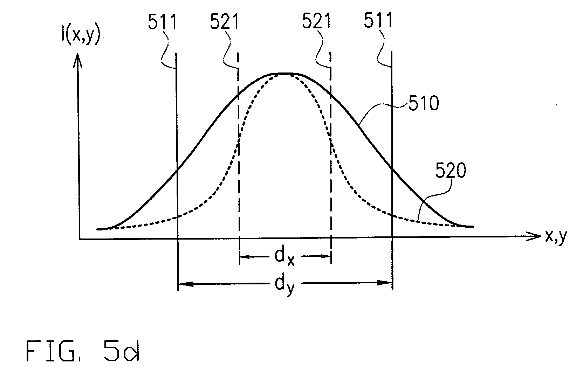

Figure 1 shows a schematic cross-sectional view of an illustrative embodiment of a single VCSEL element 100. A laser active region 103 is located, with respect to a longitudinal direction indicated by the coordinate system in Figure 1, between a first reflector means 101 and a second reflector means 102. In this embodiment, the first and second reflector means 101, 102 are formed as so-called distributed Bragg reflectors consisting of pairs of material layers having, in an alternating fashion, a high index of refraction and a low index of refraction. In this example, pairs of AlGaAs and AlAs layers are stacked to form the first and second reflector means 101, 102. The first and second reflector means are formed on a substrate 104 having a bottom metallization layer 105 that serves as a first electrode. On top of the first reflector means 101 a phase matching layer 106 is provided that has a predefined optical thickness defined by the product of the index of refraction and the thickness of the phase matching layer 106. In the embodiment depicted in Figure 1, the phase matching layer 106 substantially consists of Ga and As but any other material or combination of materials may be used so long as the optical thickness is correctly adjusted to the optical characteristics of the VCSEL 100. On top of the phase matching layer 106 a metallization layer 107 is provided with an opening to define a radiation emission window 108. The shape of the radiation emission window 108 is defined by corresponding dimensions with respect to the transverse directions represented by a first transverse direction and a second transverse direction, also referred to X-direction and Y-direction, as indicated by the coordinate system depicted in Figure 1. In the embodiment depicted in Figure 1, the shape of the radiation emission window 108 and of the entire VCSEL device is substantially circular, that is, the VCSEL device has a substantially cylindrical geometry. It should be noted that any appropriate shape of the radiation emission window 108 may be provided in conformity with design requirements by correspondingly patterning the metallization layer 107, as will be described in further detail with reference to Figures 5 and 6.

The first and second reflector means 101, 102, the phase matching layer 106, the metallization layer 107 and the radiation emission window 108 define the laser resonator of the VCSEL 100. Within the laser resonator, an aperture 109 is provided within an oxidation layer 110. The aperture 109 exhibits a relatively low electrical resistance and a high optical transmissivity for the specified radiation wavelength of the VCSEL 100. The aperture 109 may comprise a material layer having a relatively high content of aluminum, wherein the peripheral region of the oxidation layer 110 has been oxidized to form the aperture 109 having the required optical and electrical characteristics. The lateral extension of the aperture 109, i.e. the diameter, is larger than the lateral extension, i.e. the diameter of the radiation emission window 108, as indicated in Figure 1. In one illustrative embodiment, the diameter of the radiation emission window 108 is approximately 5 µm and the diameter of the aperture 109 is 7 µm and more. Furthermore, the intensity distribution of a radiation field corresponding to the fundamental transverse radiation mode is schematically depicted as a curve 111, and the intensity distribution of a higher order mode is schematically depicted as a curve 112. It is to be noted that due to the cylindrical geometry of the VCSEL 100 and the circular shape of the radiation emission window 108, the intensity distributions exhibit are substantially symmetric with respect to the longitudinal center axis of the VCSEL 100.

With reference to Figures 1-4, the principle of the present invention will be described in more detail. Due to the short dimension of the laser active region 103 with respect to the longitudinal direction, the reflector means 101 and 102 must exhibit a large reflectivity so that the radiation field can exceed the laser threshold required for stimulated emission. Accordingly, the reflector means 101 and 102 must have a reflectivity of about 99% and more to maintain the number of photons emitted by stimulated emission above the threshold value.

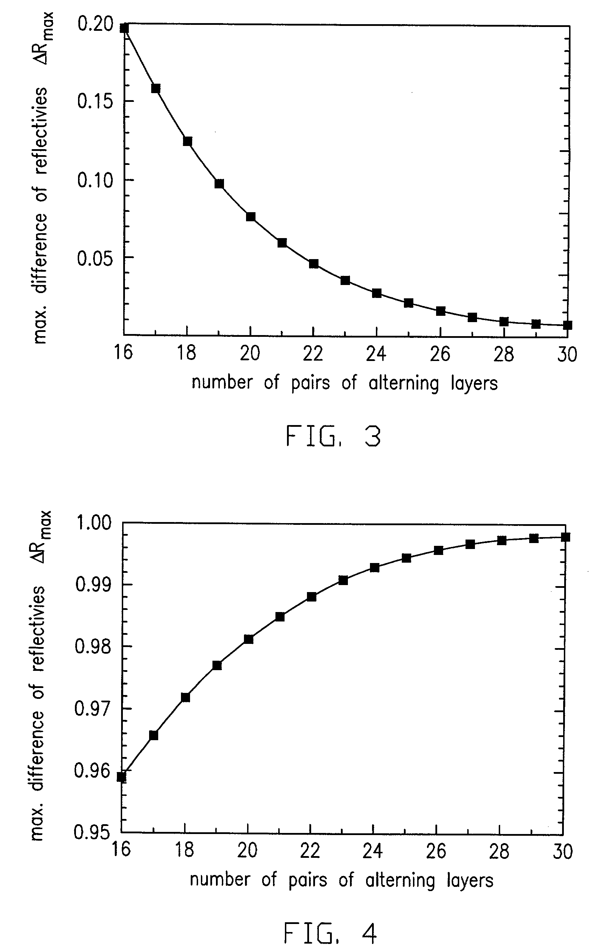

Figure 4 shows a graph illustrating the dependency of the maximum reflectivity of the Bragg reflectors 101 and 102 from the numbers of pairs of layers having a high index of refraction and a low index of refraction in an alternating fashion. It can be seen from Figure 4 that in this embodiment, assuming AlAs layers with a thickness of 63 nanometers and Al_{0.3}Ga_{0.62}As layers with a thickness of 56 nanometers, a minimum number of about 22 pairs is necessary to achieve a reflectivity of about 99% at 760 nm. Furthermore, the reflecting characteristics of the Bragg reflector 101 do not exclusively depend on the number of pairs of layers, but also depend on the characteristics of the phase matching layer 106 and the metallization layer 107 including the radiation emission window 108. For example, the reflectivity at the transition between the phase matching layer 106 and air, i.e. at the radiation emission window 108, is about 30%, assuming that the phase matching layer 102 substantially consists of Ga and As. The reflectivity at the interface between the phase matching layer 106 and the metallization layer 107 consisting of Ti, Pt and Au is also about 30%, wherein the phases of beams reflected at the radiation emission window 108 and the metallization layer 107 differ from each other depending on the index of refraction and the absorption coefficients of the corresponding materials. Consequently, the optical thickness, i.e. the thickness of phase matching layer 106 for a given index of refraction, is optimized to yield a maximum reflectivity difference between a region of the laser resonator covered by the metallization layer 107 and a region covered by the radiation emission window 108.

Figure 2 shows the results of a transfer-matrix calculation for a 760 nm AlGaAs/AlAs VCSEL comprising a Ti/Pt/Au metallization layer 107. The solid line in Figure 2 shows the variation of the reflectivity of the Bragg reflector 101 with respect to a varying thickness of the phase matching layer 106. For the parameters given above, a minimum reflectivity is obtained at a thickness of about 50 nanometers, whereas the reflectivity of the Bragg reflector 101 without the metallization layer 107, indicated by the dashed line in Figure 2, exhibits a relatively large reflectivity of over 99%, resulting in a maximum relativity difference indicated by ΔRmax in Figure 2. Thus, by appropriately adjusting the optical thickness of the phase matching layer 106 to the parameters of the Bragg reflectors 101 and/or 102 the reflectivity and hence the losses of the reflectors 101, 102 can be "patterned" in the transverse directions. As a consequence, radiation modes having a high intensity at transverse positions corresponding to areas of low reflectivity are strongly suppressed compared to the radiation mode having a maximum intensity under the radiation emission window 108.

Again referring to Figure 1, the transverse reflectivity of the VCSEL device 100 is precisely patterned by the dimensions of the radiation emission window 108. Thus, the fundamental radiation mode represented by the curve 111 will dominate over the higher radiation modes that would have higher intensities at transverse positions with a relatively low reflectivity of about 96%.

It is to be noted that the maximum reflectivity difference varies with the number of pairs used in the corresponding Bragg reflector and, in particular, that it increases with a decreasing number of pairs of layer. Figure 3 shows a graph depicting the dependence of the maximum difference of reflectivities ΔRmax on the number of pairs of layers in the Bragg reflector. Although it is desirable to have a ΔRmax that is as large as possible, a number of pairs in the Bragg reflector cannot be arbitrarily decreased, since a minimum number of pairs is necessary to obtain the required minimum reflectivity for exceeding the laser threshold, as was previously explained. Thus, 22-26 pairs of alternating layers with the above-given parameters are appropriate to achieve a ΔRmax in the range of 3-5%.

It is important to note that the above calculations have to be adapted to the actual parameters for a VCSEL device under consideration. Especially the phase matching layer 106 may comprise different types of material, such as polymers, silicon nitride and other dielectric materials having an index of refraction other than air. Moreover, the phase matching layer 106 may comprise an AlGaAs layer and may also comprise In or P depending on the wavelength of the VCSEL. Furthermore, the phase matching layer 106 may be positioned anywhere in the first and second reflector means 101, 102, for example, on top of the second reflector means 102 or between the layers of the first and second reflector means 101, 102. Moreover, the phase matching layer 106 may be provided as two or more sub-layers arranged as a stack or distributed over the first and/or second reflector means 101 and 102.

Again with reference to Figure 1, the oxidation layer 110 including the aperture 109 is provided to assist the transverse patterning of the intensity distribution of the radiation field. The aperture 109 in combination with the oxidation layer 110 serves, firstly, to guide the electrical current injected by connecting the metallization layer 107 and the metallization layer 105 to an appropriate current supply, into the active region 103 where electrons and holes recombine to generate photons; and, secondly, to optically confine the radiation field due to the significantly reduced transmissivity of the oxidation layer 110 compared to the aperture 109. In contrast to prior art devices, the aperture 109 according the present embodiment may have a larger transverse extension than the radiation emission window 108 without introducing higher radiation modes, since the dominant factor in transversely patterning the radiation field is the phase matching layer 106 in combination with the radiation emission window 108, creating a reflectivity difference to significantly increase the losses for the higher order radiation modes. Hence, it is no longer necessary to select the dimensions of the aperture 109 in the range of 1-5 µm, depending on the wavelength, in order to obtain a single mode radiation, which is the case in the prior art wherein the current density in the aperture is correspondingly increased, resulting in reduced lifetime and reliability. Contrary to this, the present embodiment allows to enlarge the aperture 109 to more than 5µm, for example 7-10 µm, to thereby optimize the recombination rate at the active region by only slightly concentrating charge carriers in the active region 103 while maintaining at the same time the current density at a relatively low level that considerably improves lifetime and reliability of the device compared to the high current density within the aperture of a prior art device. Moreover, in prior art devices, a variation of the transverse dimensions of the oxide aperture, due to a variation in the oxidation depth owing to process fluctuations or wafer inhomogeneities, considerably change the electro-optical characteristics such as threshold current, resistance, efficiency, maximum output power, side mode suppression, and single mode output power of the VCSEL device. Since the dimension of the aperture 109 is no longer the dominant factor for determining the optical characteristics of the laser resonator, the VCSEL device 100 is less sensitive to any variations in the oxidation depth which occur during the formation of the aperture 109.

The same applies for an aperture that is formed by ion implantation or a combination of oxidation and ion implantation.

With reference to Figures 5 and 6, further illustrative embodiments will be described that, in addition to single mode output, show none or at least a considerably reduced number of polarization flips, regardless of the amount of injection current within a wide range.

Figure 5a shows a schematic top view of a VCSEL device 500 that comprises a radiation emission window 508 and a metallization layer 507. The transverse reflectivity of the VCSEL 500 is patterned in accordance with the principles as explained with reference to Figures 1-4. Thus, a phase matching layer (not shown) is provided in the VCSEL 500 to create a maximum reflectivity difference between an area below the metallization layer 507 and an area below the radiation emission window 508. The radiation emission window 508 has a lateral extension along a first transverse direction, also referred to as X-direction, that is significantly smaller than a lateral extension along a second transverse direction, also referred to as Y-direction, such that the cylindrical symmetry of the VCSEL 500 is broken. Since the radiation emitted from the radiation emission window 508 is substantially linearly polarized, the probability for one linear polarization state may be significantly larger than for the other linear polarization state, in particular when the X-and Y-directions are selected to substantially coincide with the crystallographic axis [011] and [01-1], respectively.

Figure 5d is a graph depicting the intensity distribution of the fundamental radiation mode with respect to the X- and Y-directions. In Figure 5d, a curve 510 (solid line) represents the intensity distribution of the fundamental radiation mode along the Y-direction and the vertical lines 511 indicate the transverse extension d_{Y} of the radiation emission window 508 along the Y-direction. A curve 520 (dashed line) represents the intensity distribution along the X-direction, wherein the vertical lines 521 indicate the transverse extension d_{X} of the radiation emission window 508 along the X-direction. In this illustrative embodiment, d_{X} may range from 1-3 µm, whereas d_{Y} is in the range of 4-10 µm. Thus, a strong asymmetry with respect to the orthogonal directions X and Y (of the intensities) is obtained, which forces the VCSEL to substantially emit only one of the two linear polarization directions.

In the right part of Figure 5a, a further variation is depicted, wherein the VCSEL device 500 further comprises an aperture 509 that may be formed in accordance with the principles as previously explained with reference to Figures 1-4. The aperture 509 exhibits a cylindrical symmetry similar to the VCSEL device 500 to achieve, for example, a cylindrically symmetric current distribution in the active region. Patterning of the transverse reflectivity in conformity with the transverse dimensions of the radiation emission window 508 will thus lead to a significant deviation from the cylindrical symmetry of the resulting radiation field, and will therefore favor one of the two linear polarization directions.

Figure 5b schematically shows a top view of a further illustrative embodiment to create a sufficient asymmetry so as to stabilize one of the two linear polarization directions. In the left part of Figure 5b, a cylindrical VCSEL device 500 comprises an eye-shaped radiation emission window formed in the metallization layer 507. Again, the transverse structure of the reflectivity within the VCSEL device 500 exhibits a strong asymmetry, which will significantly increase the losses for one of the linear polarization directions such that the VCSEL device will constantly emit in one of the polarization directions.

The right part of Figure 5b shows a further preferred embodiment additionally comprising the aperture 509 to provide a cylindrically symmetric current density in the laser active region. The circular aperture 509 in combination with the I-shaped radiation emission window 508 forces the VCSEL element 500 to emit with only one linear polarization direction.

Figure 5c shows a further illustrative embodiment of the VCSEL device 500. The VCSEL device 500 comprises a circular aperture 509 centrally located within the VCSEL device 500. The circular radiation emission window 508 having a center point that is offset from the center point of the aperture 509 is arranged within the aperture 509 to create an asymmetric intensity distribution of the radiation field. Accordingly, the finally emitted radiation will comprise substantially one singular linear polarization state.

It should be noted that the embodiments shown in Figure 5 are only of illustrative nature and the shapes of the radiation emission windows 508 and/or the shapes of the apertures 509 may take any appropriate shape in so far as an asymmetric distribution of the radiation field is obtained. In particular, the embodiments depicted in Figure 5 may be combined in any appropriate way to still achieve the advantages in accordance with the present invention. Furthermore, the VCSEL devices 500 in Figure 5 are shown as and described as cylindrical devices, but any other shape such as rectangular-shaped, square-shaped, hexagonal-shaped device, etc. may be used.

Figure 6 shows a schematic top view of a further embodiment in accordance with the present invention. A VCSEL device 600 comprises a metallization layer 607 in which a radiation emission window 608 is formed. In this embodiment, the VCSEL device 600 and the radiation emission window are of circular shape, but as previously explained any appropriate geometrical form may be employed. In many applications, however, a circular beam having a substantial Gaussian profile is preferable. In the radiation emission window 608, a fine grid 610 is formed. Preferably, the fine grid 610 is formed of a metal such as that used for the metallization layer so that the reflectivity within the radiation emission window 608 is patterned in accordance with the bars forming the fine grid 610. The fine grid 610, however, must not necessarily comprise the same material as the metallization layer 607. The bars of the fine grid 610 may be made of SiN, polymer, and the like. In such a case, the reflectivity difference created by the fine grid 610 would then be significantly smaller than the maximum reflectivity difference between the radiation emission window 608 and the metallization layer 607, but may nevertheless be sufficient to provide a "fine" structure of reflectivity variations within the radiation emission window 608. The fine grid 610 may also be considered as a grid having a first periodicity along the X-direction and/or having a second periodicity along the Y-direction, and vice versa. Thus, the fine grid 610 produces periodic disturbances of the reflectivity, and hence of the intensity distribution within the radiation emission window 608, which leads to an asymmetric distribution with respect to the X- and Y-directions due to the different periodicities. Consequently, a laser beam emitted by the VCSEL device 600 will exhibit substantially one linear polarization state. The embodiment shown in Figure 6 may also comprise an aperture (not shown) to appropriately adjust the current density within the laser active region as has been previously explained. Moreover, the geometric shape of the radiation emission window 608 and/or of the aperture may be designed in numerous ways, as was explained with reference to the embodiments depicted in Figure 5. Furthermore, the fine grid 601 may also be employed in combination with the embodiments described with reference to Figures 1-5. With regards to obtaining a maximum output power, the width of a single bar of the fine grid 610 may be selected to have a width in the range of several hundred nanometers to 1 µm, so that as little surface area as possible is "wasted".

## Claims

1. A vertical-cavity-surface-emitting laser (VCSEL) comprising:
a first reflector means (101) and a second reflector means (102) arranged to define a laser resonator extending along a longitudinal direction and along transverse directions;
a laser active region (103) located between the first and second reflector means (101, 102),
a metal layer (107) at the first or second reflector means (101, 102) and patterned to form a radiation emission window (108),
a phase matching layer (106) arranged within the resonator and having an optical thickness adapted to transversely pattern a reflectivity of the first and/or second reflector means (101, 102), and
an aperture (109) formed between the first and second reflector means (101, 102), wherein a mode selectivity of the VCSEL is substantially determined by a reflectivity difference defined by the transverse dimensions of the radiation emission window (108).

2. The VCSEL of claim 1, wherein a transverse dimension of the aperture along a first transverse direction and/or a transverse dimension of the aperture along a second transverse direction is larger than the transverse dimensions of the radiation emission window.

3. The VCSEL of claim 2, wherein a transverse dimension of the radiation emission window in the first transverse direction is different from a transverse dimension of the radiation emission window along the second transverse direction.

4. The VCSEL of any of claims 1 to 3, wherein the aperture is formed by selective oxidation of an aluminum containing material layer and/or by proton implantation.

5. The VCSEL of claim 1, wherein the radiation emission window is of substantially circular shape with a diameter that is less than a diameter of the aperture.

6. The VCSEL device of claim 5, wherein the diameter of the radiation emission window is in the range of 1-5 µm to select the fundamental radiation mode.

7. The VCSEL of claim 5 or 6, wherein the diameter of the aperture is selected to limit a maximum current density within said aperture.

8. The VCSEL of one of the preceding claims, wherein the phase matching layer is provided in the first and/or the second reflector means.

9. The VCSEL of claim 8, wherein the phase matching layer comprises at least two sub-layers.

10. The VCSEL of claim 9, wherein at least one of the at least two sub-layers is separated from the other one of said at least two sub-layers,

11. The VCSEL of any of the preceding claims, wherein the phase matching layer comprises Ga and/or As and/or Al and/or In and/or P and/or a polymer and/or a dielectric material having an index of refraction greater than 1, and/or silicon nitride.

12. A VCSEL comprising:
a first reflector means (101) and a second reflector means (102) arranged to define a laser resonator extending along a longitudinal direction and along transverse directions, represented by a first transverse direction and a second transverse direction,
a laser active region (103) located between the first and the second reflector means (101, 102),
a metal layer (507) at the first or second reflector means (101, 102), patterned to form a radiation emission window (508) having a first lateral extension along the first transverse direction and a second lateral extension along the second transverse direction, and
a phase matching layer (106) arranged in the laser resonator and having an optical thickness adapted to transversely pattern the reflectivity of the first and/or second reflector means (101, 102) to select the fundamental transverse radiation mode,
**characterized in that**
the first lateral extension is different from the second lateral extension to cause a
direction-dependent loss of the transverse radiation mode within the laser resonator.

13. The VCSEL of claim 12, wherein the first and second transverse directions are orthogonal.

14. The VCSEL of claim 12 or 13, wherein the radiation emission window is axially symmetric with respect to the first and/or second transverse direction.

15. The VCSEL of any of the claims 12-14, further comprising an aperture formed in the laser resonator and having a first lateral extension along the first transverse direction and a second lateral extension along the second transverse direction.

16. The VCSEL of claim 15, wherein at least one of the first and second lateral extensions of the aperture is larger than one of the first and second lateral extensions of the radiation emission window.

17. The VCSEL of claim 16, wherein the aperture is formed by selective oxidation of an aluminum containing material layer and/or by ion implantation.

18. The VCSEL of claim 17, wherein a center of the radiation emission window and a center of the aperture are located on the same longitudinal axis.

19. The VCSEL of claim 18, wherein the aperture is point symmetric with respect to a longitudinal axis accommodating the center point of the aperture.

20. The VCSEL of claim 19, wherein the first lateral extension of the aperture is different from the second lateral extension of the aperture.

21. The VCSEL of claim 20, wherein the center of the radiation emission window is located at a longitudinal axis that is spaced apart from the longitudinal axis comprising the center of the aperture.

22. A VCSEL comprising:
a first reflector means (101) and a second reflector means (102) arranged to define a laser resonator extending along a longitudinal direction and along transverse directions represented by a first transverse direction and a second transverse direction,
a laser active region (103) located between the first and second reflector means (101, 102),
a metal layer (507) at the first or second reflector means (101, 102), patterned to form a radiation emission window (508),
a phase matching layer (106) arranged in the laser resonator and having an optical thickness adapted to transversely pattern the reflectivity of the first and/or second reflector means (101, 102) to select the fundamental transverse radiation mode, and
an aperture (509) formed within the laser resonator, wherein a center of the aperture (509) and a center of the radiation emission window (508) are located on different longitudinal axes.

23. The VCSEL of claim 22, wherein the aperture and the radiation emission window are each point symmetric with respect to their corresponding center points.

24. The VCSEL device of claim 23, wherein a diameter of the aperture is larger than a diameter of the radiation emission window.

25. A VCSEL comprising:
a first reflector means (101) and a second reflector means (102) arranged to define a laser resonator extending along a longitudinal direction and along transverse directions,
a laser active region (103) located between the first and second reflector means (101, 102),
a metal layer (607) at the first or second reflector means (101, 102), patterned to form a radiation emission window (608),
a phase matching layer (106) arranged in the laser resonator and having an optical thickness adapted to transversely pattern the reflectivity of the first and/or reflector means (101, 102) to select the fundamental transverse radiation mode, and
a fine grid (610) provided within the radiation emission window (608) and having a first periodicity along a first transverse direction and/or a second periodicity along the second transverse direction, wherein the first periodicity is different from the second periodicity.

26. The VCSEL of claim 25, wherein the fine grid is a metal grid.
